# EUROPEAN PATENT APPLICATION

(11) **EP 4 773 757 A2**
(43) Date of publication of application: **08.07.2026**
(21) Application number: 26180904.0
(22) Date of filing: 28.12.2023
(51) Int. Cl.: H10F 10/161

(54) **SOLAR CELL AND PHOTOVOLTAIC MODULE**

(30) Priority: 15.09.2023 CN 202311197426
(62) Divisional of application: 23220573.2
(71) Applicant: JINKO SOLAR CO., LTD, ShangRao, Jiangxi 334100 (CN); Zhejiang Jinko Solar Co., Ltd., Haining, Zhejiang 314416 (CN)
(72) Inventor: ZHANG, Yuanfang, Shangrao, Jiangxi, 334100 (CN); XU, Menglei, Shangrao, Jiangxi, 334100 (CN); YANG, Jie, Shangrao, Jiangxi, 334100 (CN); ZHANG, Xinyu, Shangrao, Jiangxi, 334100 (CN)
(74) Representative: Balder IP Law, S.L.

(57) **Abstract**

Embodiments of the present disclosure relate to a solar cell and a photovoltaic module. The solar cell includes a thin-film solar cell and a bottom cell stacked in a first direction. The bottom cell includes: a transparent conductive layer, a first doped conductive layer, an intrinsic amorphous silicon layer, a substrate, a second doped conductive layer, and one or more electrodes that are stacked in the first direction. The transparent conductive layer is between the thin-film solar cell and the first doped conductive layer, and the one or more electrodes are formed on a side of the second doped conductive layer away from the substrate and are in ohmic contact with the second doped conductive layer. The first doped conductive layer includes a doped amorphous silicon layer or a doped microcrystalline silicon layer. The solar cell is at least conducive to reduction of the collection loss of carriers of the solar cell and improvement of photoelectric conversion efficiency of the solar cell.

## Description

### TECHNICAL FIELD

Embodiments of the present disclosure relate to the field of solar cell technology, and in particular to a solar cell and a photovoltaic module.

### BACKGROUND

Fossil energy may cause atmospheric pollution and has limited reserves. In contrast, solar energy has advantages such as cleanliness, pollution-free, and abundant reserves. Therefore, solar energy is gradually becoming the core clean energy substitute for fossil energy. Due to the good photoelectric conversion efficiency of solar cells, solar cells have become the focus of development for clean energy utilization.

The existing solar cells are limited by the wavelength range of light which is suitable to be absorbed and utilized, resulting in limited photoelectric conversion efficiency. In order to further improve the photoelectric conversion efficiency of solar cells, thin-film solar cells and crystalline silicon solar cells that absorb light of different wavelengths may be stacked into tandem solar cells, thereby improving the photoelectric conversion efficiency of solar cells. However, there is a significant deviation between the photoelectric conversion efficiency of the existing tandem solar cells and theoretical photoelectric conversion efficiency.

### SUMMARY

Embodiments of the present disclosure provide a solar cell and a photovoltaic module, which are at least conducive to improvement of photoelectric conversion efficiency of solar cells.

Some embodiments of the present disclosure provide a solar cell including a thin-film solar cell and a bottom cell stacked in a first direction. The bottom cell includes a transparent conductive layer, a first doped conductive layer, an intrinsic amorphous silicon layer, a substrate, a second doped conductive layer, and one or more electrodes that are stacked in the first direction. The transparent conductive layer is between the thin-film solar cell and the first doped conductive layer, and the one or more electrodes are formed on a side of the second doped conductive layer away from the substrate and are in ohmic contact with the second doped conductive layer. The first doped conductive layer includes a doped amorphous silicon layer or a doped microcrystalline silicon layer.

In some embodiments, a surface of the substrate facing towards the intrinsic amorphous silicon layer has a plurality of textured structures.

In some embodiments, heights of the plurality of textured structures of the surface of the substrate facing towards the intrinsic amorphous silicon layer in the first direction range from 50nm to 1µm.

In some embodiments, each of the substrate and the first doped conductive layer includes first doped ions, the second doped conductive layer includes second doped ions, and the first doped ions are P-type ions and the second doped ions are N-type ions, or the first doped ions are N-type ions and the second doped ions are P-type ions.

In some embodiments, doping concentration of the first doped ions in the first doped conductive layer ranges from 10¹⁷/cm³ to 10¹⁹/cm³.

In some embodiments, the second doped conductive layer has first doped regions and second doped regions, and the first doped regions interleave with the second doped regions in a second direction. Doping concentration of doped ions in the first doped regions is greater than doping concentration of doped ions in the second doped regions. The one or more electrodes are in ohmic contact with the first doped regions.

In some embodiments, surfaces of the first doped regions facing towards the one or more electrodes are textured surfaces.

In some embodiments, one or more orthographic projections of the one or more electrodes on a surface of the second doped conductive layer facing towards the one or more electrodes are located within one or more respective first doped regions of the first doped regions.

In some embodiments, a thickness of the first doped conductive layer in the first direction ranges from 5nm to 30nm.

In some embodiments, a thickness of the intrinsic amorphous silicon layer in the first direction ranges from 1nm to 10nm.

In some embodiments, the thin-film solar cell includes a perovskite thin-film solar cell, a copper indium gallium diselenide (CIGS) thin-film solar cell, a cadmium telluride thin-film solar cell, or a III to V-group thin-film solar cell.

Some embodiments of the present disclosure provide a photovoltaic module, including: one or more cell strings formed by connecting a plurality of the solar cells as above described; one or more encapsulation layers configured to cover at least one surface of the one or more cell strings; and one or more cover plates configured to cover at least one surface of the one or more encapsulation layers away from the one or more cell strings.

### BRIEF DESCRIPTION OF THE DRAWINGS

One or more embodiments are exemplarily illustrated in reference to corresponding accompanying drawing(s), and these exemplary illustrations do not constitute limitations on the embodiments. Unless otherwise stated, the accompanying drawings do not constitute scale limitations.
FIG. 1 is a schematic diagram of a sectional structure of a solar cell according to some embodiments of the present disclosure.
FIG. 2 is a schematic diagram of a sectional structure of another solar cell according to some embodiments of the present disclosure.
FIG. 3 is a schematic diagram of a sectional structure of yet another solar cell according to some embodiments of the present disclosure.
FIG. 4 is a schematic diagram of a sectional structure of still another solar cell according to some embodiments of the present disclosure.
FIG. 5 is a schematic diagram of a sectional structure of one more solar cell according to some embodiments of the present disclosure.
FIG. 6 is a schematic diagram of a sectional structure of one more solar cell according to some embodiments of the present disclosure.
FIG. 7 is a schematic diagram of a sectional structure of one more solar cell according to some embodiments of the present disclosure.
FIG. 8 is a structural schematic diagram of a photovoltaic module according to some embodiments of the present disclosure.

### DETAILED DESCRIPTION OF THE EMBODIMENTS

When a certain part "includes" another part throughout the specification, other parts are not excluded unless otherwise stated, and other parts may be further included. In addition, when parts such as a layer, a film, a region, or a plate is referred to as being "on" another part, it may be "directly on" another part or may have another part present therebetween. In addition, when a part of a layer, film, region, plate, etc., is "directly on" another part, it means that no other part is positioned therebetween.

The terminology used in the description of the various described embodiments herein is for the purpose of describing particular embodiments only and is not intended to be limiting. As used in the description of the various described embodiments and the appended claims, the singular forms "a", "an" and "the" are intended to include the plural forms as well, unless the context clearly indicates otherwise.

It can be known from the background art that there is a significant deviation between the photoelectric conversion efficiency of the existing tandem solar cells and theoretical photoelectric conversion efficiency. The reasons why the photoelectric conversion efficiency of a tandem solar cell is limited include the recombination loss between a bottom cell and a top cell, as well as the performance loss of the bottom cell. In an existing process of manufacturing tandem solar cells, some of the structure of the bottom cell is generally removed, then a transparent conductive layer is formed on the exposed semiconductor conductive layer of the bottom cell as a functional layer connecting the bottom cell and the top cell, and then the top cell is formed on the transparent conductive layer. Due to the removal of some of the structure of the bottom cell, the loss in open-circuit voltage of the bottom cell increases, and the photoelectric conversion efficiency of the bottom cell decreases, thereby limiting the actual photoelectric conversion efficiency of the tandem solar cell. When the transparent conductive layer and the top cell are directly formed on the original structure of the bottom cell, a metal-semiconductor contact is formed between the electrodes of the bottom cell and the transparent conductive layer, thereby greatly increasing the contact recombination between the top cell and the bottom cell, which also limits the photovoltaic conversion efficiency of the tandem solar cell, and leads to an excessive thickness of the formed tandem solar cell.

Some embodiments of the present disclosure provide a tandem solar cell, in the tandem solar cell, the bottom cell is mainly based on a tunnel oxide passivated contact solar cell, with a back structure of the tunnel oxide passivated contact solar cell being replaced with a back structure of a heterojunction solar cell, and the thin-film solar cell and the bottom cell are connected using the transparent conductive layer in the back structure of the heterojunction solar cell. With the replacement of the back structure of the bottom cell, the bottom cell in the tandem solar cell can have a complete back structure, which can improve the open-circuit voltage of the bottom cell, and can prevent the formation of metal-semiconductor contact between the electrodes on the back surface and an intermediate layer when the bottom cell having the complete structure is connected with the thin-film solar cell through the intermediate layer. In this way, the contact recombination between the thin-film solar cell and the bottom cell can be reduced, and the photoelectric conversion efficiency of the solar cell can be improved. Moreover, due to the transparent conductive layer in the structure of the bottom cell on a side facing to the thin-film solar cell, there is no need to form an additional intermediate layer to connect the bottom cell and top cell, thereby reducing the overall thickness and cost of the tandem solar cell.

Embodiments of the present disclosure will be described in detail below with reference to the accompanying drawings. Those skilled in the art should understand that, in the embodiments of the present disclosure, many technical details are provided for the reader to better understand the present disclosure. However, even without these technical details and various modifications and variants based on the following embodiments, the technical solutions claimed in the present disclosure can be implemented.

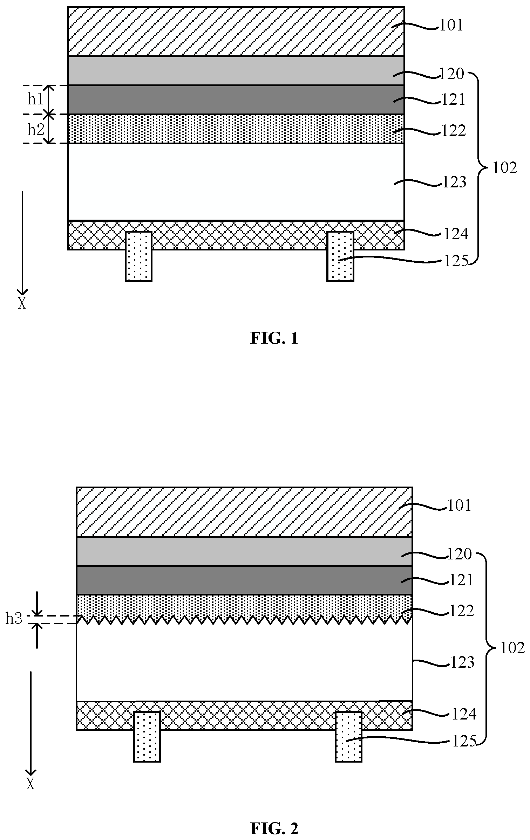

Some embodiments of the present disclosure provide a solar cell. Referring to FIG. 1, FIG. 1 is a schematic diagram of a sectional structure of the solar cell, and in FIG. 1, the X direction represents the first direction.

The solar cell includes a thin-film solar cell 101 and a bottom cell 102 stacked in the first direction. The bottom cell 102 includes a transparent conductive layer 120, a first doped conductive layer 121, an intrinsic amorphous silicon layer 122, a substrate 123, a second doped conductive layer 124, and one or more electrodes 125 that are stacked in the first direction. The transparent conductive layer 120 is between the thin-film solar cell 101 and the first doped conductive layer 121, and the one or more electrodes 125 are disposed on a side of the second doped conductive layer 124 away from the substrate 123 and are in ohmic contact with the second doped conductive layer 124. The first doped conductive layer 121 includes a doped amorphous silicon layer or a doped microcrystalline silicon layer.

In the tandem solar cell, the bottom cell 102 is mainly based on a tunnel oxide passivated contact solar cell, with a back structure of the tunnel oxide passivated contact solar cell being replaced with a back structure of a heterojunction solar cell, and the thin-film solar cell 101 and the bottom cell 102 are connected using the transparent conductive layer 120 in the back structure of the heterojunction solar cell. With the adjustment of the back structure of the bottom cell 102, the bottom cell 102 can have a complete back structure, which can improve the open-circuit voltage of the bottom cell 102, and can prevent the formation of metal-semiconductor contact between the electrodes on the back surface of the bottom cell 102 and an intermediate layer when the bottom cell 102 having the complete back structure is connected with the thin-film solar cell 101 through the intermediate layer. In this way, the contact recombination between the thin-film solar cell 101 and the bottom cell 102 can be reduced, and the photoelectric conversion efficiency of the solar cell can be improved. Moreover, due to the transparent conductive layer 120 in the structure of the bottom cell 102 on a side facing to the thin-film solar cell 101, there is no need to form an additional intermediate layer to connect the bottom cell 102 and thin-film solar cell 101, thereby reducing the overall thickness and cost of the tandem solar cell.

In some embodiments, material of the substrate 123 may be an elemental semiconductor material. In some embodiments, the elemental semiconductor material may be composed of a single element, such as silicon or germanium. The elemental semiconductor material may be in a monocrystalline state, a polycrystalline state, an amorphous state, or a microcrystalline state (in which the monocrystalline state and the amorphous state present concurrently). For example, silicon may be at least one of monocrystalline silicon, polycrystalline silicon, amorphous silicon, or microcrystalline silicon.

The material of the substrate 123 also may be a compound semiconductor material. Common compound semiconductor materials include, but are not limited to, materials such as silicon germanide, silicon carbide, gallium arsenide, indium gallide, perovskite, cadmium telluride, copper indium selenium, or the like. The substrate 123 also may be a sapphire substrate, a silicon substrate disposed on an insulator, or a germanium substrate disposed on an insulator.

The substrate 123 may be an N-type semiconductor substrate or a P-type semiconductor substrate. The N-type semiconductor substrate is doped with an N-type doping element, which may be any of the V-group elements such as phosphorus (P), bismuth (Bi), antimony (Sb), or arsenic (As). The P-type semiconductor substrate is doped with a P-type element, which may be any of the III-group elements such as boron (B), aluminum (Al), gallium (Ga), or indium (In).

Moreover, when the solar cell receives light with a single side, the solar cell has a light-receiving surface and a back surface opposite to each other, and the back structure of the solar cell refers to the functional layers between the back surface and the substrate of the solar cell. When the solar cell receives light with both sides, the solar cell has a light-receiving surface with higher intensity of incident light and a light-receiving surface with lower intensity of incident light, and the back structure of the solar cell refers to the functional layers between the light-receiving surface with lower intensity of incident light and the substrate of the solar cell.

In some embodiments, the one or more electrodes 125 may be one or more metal electrodes with good conductivity, such as copper electrodes, silver electrodes, or aluminum electrodes. The one or more electrodes 125 may also be composed of other conductive materials with good conductivity, such as graphene electrodes or superconductor electrodes.

In some embodiments, the transparent conductive layer 120 may be at least one of an ITO film, an IZO film, an AZO film, an IWO film, a FTO film, a ZnO film, a strontium indium oxide film, or an IXO film.

The transparent conductive layer 120 may have a single-layer structure or a multi-layer structure with layers stacked in the first direction. When the transparent conductive layer 120 has a multi-layer structure, the refractive index of the layers of the transparent conductive layer 120 increases sequentially along the first direction, and the layer in contact with the first doped conductive layer 121 has the highest refractive index, thereby reducing the loss in incident light caused by light reflection before reaching the bottom cell 102.

In some embodiments, the material of the second doped conductive layer 124 may include at least one of silicon oxide, silicon nitride, silicon oxynitride, carbon nitrogen silicon oxide, titanium oxide, hafnium oxide, aluminium oxide, or the like.

In some embodiments, a thickness of the intrinsic amorphous silicon layer 122 in the first direction ranges from 1nm to 10nm.

The thickness of the intrinsic amorphous silicon layer 122 in the first direction refers to a distance h1 along the first direction between a surface of the intrinsic amorphous silicon layer 122 in contact with the substrate 123 and a surface of the intrinsic amorphous silicon layer 122 in contact with the first doped conductive layer 121.

The intrinsic amorphous silicon layer 122 is mainly used to combine with the first doped conductive layer 121 to increase the open-circuit voltage of the bottom cell 102 by field passivation. When the thickness of the intrinsic amorphous silicon layer 122 is too small, the field passivation effect is poor, which cannot effectively increase the open-circuit voltage of the bottom cell 102. When the thickness of the intrinsic amorphous silicon layer 122 is too large, the shortwave effect of the intrinsic amorphous silicon layer 122 decreases, and the absorption ability of light of relatively large wavelengths increases, resulting in a decrease in the available light received by the substrate 123.

Therefore, the thickness of the intrinsic amorphous silicon layer 122 may range from 1nm to 10nm, such as 1.25nm, 1.5nm, 1.75nm, 2.5nm, 3nm, 3.5nm, 4.75nm, 5.5nm, 6.5nm, 8nm, or 9.5nm. By setting the thickness of the intrinsic amorphous silicon layer 122 in the first direction within an appropriate range, a good field passivation effect can be achieved by a combination of the intrinsic amorphous silicon layer 122 with the first doped conductive layer 121. In this way, the open-circuit voltage of the bottom cell 102 can be increased, and the transfer ability of the carriers in the substrate 123 to the intrinsic amorphous silicon layer 122 can be improved. Moreover, excessive reduction in the shortwave effect of the intrinsic amorphous silicon layer 122 can be prevented, and the absorption ability of the intrinsic amorphous silicon layer 122 to light of relatively large wavelengths can be reduced, thereby increasing the available incident light obtained by the substrate 123, and improving the light-absorption rate of the bottom cell 102.

In some embodiments, a thickness of the first doped conductive layer 121 in the first direction ranges from 5nm to 30nm.

The thickness of the first doped conductive layer 121 in the first direction refers to a distance h2 along the first direction between a surface of the first doped conductive layer 121 in contact with the intrinsic amorphous silicon layer 122 and a surface of the first doped conductive layer 121 in contact with the transparent conductive layer 120.

The first doped conductive layer 121 is mainly used to combine with the intrinsic amorphous silicon layer 122 to provide field passivation to the bottom cell 102, and to transfer the carriers transferred from the intrinsic amorphous silicon layer 122 to the transparent conductive layer 120. When the thickness of the first doped conductive layer 121 is too small, the field passivation effect provided by the combination of the first doped conductive layer 121 with the intrinsic amorphous silicon layer 122 is limited, the loss in open-circuit voltage of the bottom cell 102 is relatively large, and the transfer ability of the carriers generated in the substrate 123 to the intrinsic amorphous silicon layer 122 and the second doped conductive layer 124 is limited. When the thickness of the first doped conductive layer 121 is too large, during transfer of the carriers through the first doped conductive layer 121 to the transparent conductive layer 120, transfer distance of the carriers is too large, and transfer loss of the carriers correspondingly increases. Moreover, during the incident light passing through the first doped conductive layer 121, the light-absorption capacity of the first doped conductive layer 121 is too high, resulting in a decrease in the available light obtained by the substrate 123.

Therefore, during forming of the first doped conductive layer 121, the thickness of the first doped conductive layer 121 in the first direction may range from 5nm to 30nm, for example, 6nm, 7.5nm, 9nm, 10nm, 12.5nm, 15.5nm, 17.5nm, 20nm, 23nm, 26nm, or 28.5nm. By setting the thickness of the first doped conductive layer 121 within an appropriate range, the field passivation effect and open-circuit voltage of the bottom cell 102 can be improved, and the absorption of the incident light of relatively large wavelengths by the first doped conductive layer 121 can be reduced. In this way, the light-absorption rate of the bottom cell 102 can be improved, thereby improving the photoelectric conversion efficiency of the bottom cell 102.

In some embodiments, each of the substrate 123 and the first doped conductive layer 121 includes first doped ions, the second doped conductive layer 124 includes second doped ions, and the first doped ions are P-type ions and the second doped ions are N-type ions, or the first doped ions are N-type ions and the second doped ions are P-type ions.

The substrate 123 of the bottom cell 102 may be either a P-type substrate or an N-type substrate. In order to form a PN junction on the side of the bottom cell 102 away from the thin-film solar cell 101, the doping type of the second doped conductive layer 124 is different from that of the substrate 123. In order to combine with the intrinsic amorphous silicon layer 122 to form a passivation structure having a field passivation effect, and to replace the reflection electrode of the bottom cell 102, the doping type of the first doped conductive layer 121 needs to be the same as the doping type of the substrate 123. Therefore, when the doping type of the substrate 123 is P-type, the first doping ions are P-type ions, and the second doping ions are N-type ions. When the doping type of the substrate 123 is N-type, the first doped ions are N-type ions, and the second doped ions are P-type ions. Based on the doping type of the substrate 123, specific types of doping are performed on the first doped conductive layer 121 and the second doped conductive layer 124 to ensure that the bottom cell 102 has good conductivity and passivation effects.

In some embodiments, doping concentration of the first doped ions in the first doped conductive layer 121 ranges from 10¹⁷/cm³ to 10¹⁹/cm³.

The doping concentration of the first doped ions in the first doped conductive layer 121 influences the conductivity and light reflection ability of the first doped conductive layer 121. When the doping concentration of the first doped ions in the first doped conductive layer 121 is too low, the conductivity of the first doped conductive layer 121 is poor, and the loss in carriers is too large during transfer of the carriers through the first doped conductive layer 121 and to the transparent conductive layer 120. When the doping concentration of the first doped ions in the first doped conductive layer 121 is too high, the light reflection ability of the first doped conductive layer 121 is too strong. The incident light propagated through the transparent conductive layer 120 will be excessively reflected at the surface of the first doped conductive layer 121 in contact with the transparent conductive layer 120, resulting in a decrease in the incident light obtained by the substrate 123 and affecting the light-absorption rate of the substrate 123.

Therefore, during forming the first doped conductive layer 121, the doping concentration of the first doped ions in the first doped conductive layer 121 may range from 10¹⁷/cm³ to 10¹⁹/cm³, for example, setting the doping concentration to 2 * 10 ¹⁷/cm³, 4 * 10¹⁷/cm³, 7.5 * 10¹⁷/cm³, 10¹⁸/cm³, 3 * 10¹⁸/cm³, 6 * 10¹⁸/cm³, 9 * 10¹⁸/cm³, or the like. By setting the concentration of the first doped ions in the first doped conductive layer 121 within an appropriate range, the conductivity of the first doped conductive layer 121 can be effectively improved, and transfer loss of the carriers during transfer through the first doped conductive layer 121 can be reduced. In this way, the light reflection ability of the first doped conductive layer 121 can be effectively controlled, the loss of the incident light passing through the first doped conductive layer 121 can be reduced, the light-absorption rate of the substrate 123 can be improved, thereby improving the photoelectric conversion efficiency of the bottom cell 102.

Referring to FIGS. 1 and 2 in combination, FIG. 2 is a schematic diagram of a sectional structure of another solar cell. In FIG. 2, a surface of the substrate 123 facing towards the intrinsic amorphous silicon layer 122 has a plurality of textured structures. In some embodiments, the surface of the substrate 123 facing towards the intrinsic amorphous silicon layer 122 is a textured surface.

During production of the bottom cell 102, morphology of the surface of the substrate 123 will influence the photoelectric conversion performance of the substrate 123. When the surface of the substrate 123 is a polished surface, that is, the surface of the substrate 123 is a smooth surface, the carrier recombination current at the surface of the substrate 123 is the smallest, but the optical path of the incident light in the substrate 123 is relatively short, and the light-absorption rate of the substrate 123 is relatively low. Moreover, the contact area between the substrate 123 and other functional layers is relatively small, and the carriers generated in the substrate 123 undergo a significant loss during transfer to the intrinsic amorphous silicon layer 122.

Therefore, the morphology of the surface of the substrate 123 facing towards the intrinsic amorphous silicon layer 122 may be set to a textured morphology. The plurality of textured structures can increase the optical path of incident light in the substrate 123 and reduce the loss of carriers in the substrate 123 during transfer to the intrinsic amorphous silicon layer 122. In this way, the loss in photoelectric conversion efficiency caused by the increase in carrier recombination current at the surface of the substrate 123 can be compensated, thereby further improving the photoelectric conversion efficiency of the bottom cell 102.

Moreover, the intrinsic amorphous silicon layer 122, the first doped conductive layer 121, and the transparent conductive layer 120 may be formed directly on the surface of the substrate 123 using a deposition process. When the surface of the substrate 123 facing towards the intrinsic amorphous silicon layer 122 has a plurality of textured structures, each of a surface of the intrinsic amorphous silicon layer 122, a surface of the first doped conductive layer 121, and a surface of the transparent conductive layer 120 which are away from the substrate 123 in the first direction has a plurality of textured structures. The textured structures of the transparent conductive layer 120 can play a role in trapping light and reducing reflection, i.e. reducing the reflection of light incident onto the surface of the bottom cell 102 by the transparent conductive layer 120, thereby improving the light-absorption rate of the bottom cell 102, and improving the photoelectric conversion efficiency of the bottom cell 102. The textured structures of the surface of the transparent conductive layer 120, of the surface of the first doped conductive layer 121, and of the surface of the intrinsic amorphous silicon layer 122 also can reduce the transfer loss of carriers between the thin-film solar cell 101 and the bottom cell 102. The deposition process includes chemical vapor deposition, physical vapor deposition, atomic layer deposition, or the like.

In some embodiments, heights of the plurality of textured structures of the surface of the substrate 123 facing towards the intrinsic amorphous silicon layer 122 in the first direction range from 50nm to 1µm.

A height of one respective textured structure of the plurality of textured structures in the first direction refers to a maximum distance h3 along the first direction between any point on the one respective textured structure and the surface of the substrate 123 facing towards the intrinsic amorphous silicon layer 122.

Referring to the above analysis on the influence of morphology of the surface of the substrate 123 on the photoelectric conversion performance of the substrate 123, when the surface of the substrate 123 facing towards the intrinsic amorphous silicon layer 122 has a plurality of textured structures, the carrier recombination current at the surface of substrate 123 increases to some extent. Due to the limited available light by the substrate 123, the effect of improving light-absorption rate by the textured structures has an upper limit. When the heights of the plurality of textured structures of the surface of the substrate 123 facing towards the intrinsic amorphous silicon layer 122 in the first direction are too large, the influence of the increase in light-absorption rate and the reduction in the transfer loss of carriers resulted by the textured structures to photoelectric conversion efficiency may be less than the influence of the increase in carrier recombination current to the photoelectric conversion efficiency, resulting in the substrate 123 having textured structures being unable to effectively improve the photoelectric conversion efficiency of the bottom cell 102, or even leading to a decrease in the photoelectric conversion efficiency of the bottom cell 102.

Moreover, a minimum increase in carrier recombination current of the substrate 123 caused by the textured structures is greater than a minimum increase in the light-absorption rate of the substrate 123 caused by the textured structures. Thus, when the heights of the plurality of textured structures of the surface of the substrate 123 facing towards the intrinsic amorphous silicon layer 122 in the first direction are too small, the influence of the increase in light-absorption rate and the reduction in the transfer loss of carriers resulted by the textured structures to photoelectric conversion efficiency of the bottom cell 102 also may be less than the influence of the increase in carrier recombination current resulted by the textured structures to the photoelectric conversion efficiency of the bottom cell 102.

Therefore, the heights of the plurality of textured structures of the surface of the substrate 123 facing towards the intrinsic amorphous silicon layer 122 in the first direction may range from 50nm to 1µm, for example, 55nm, 65nm, 80nm, 100nm, 125nm, 150nm, 200nm, 250nm, 325nm, 400nm, 500nm, 650nm, 800nm, or 950nm. The use of the textured structures can improve the light-absorption rate and reduce the transfer loss of carriers, thereby effectively compensating for the impact of increased carrier recombination current on the photoelectric conversion efficiency of the bottom cell 102, and improving the photoelectric conversion efficiency of the solar cell.

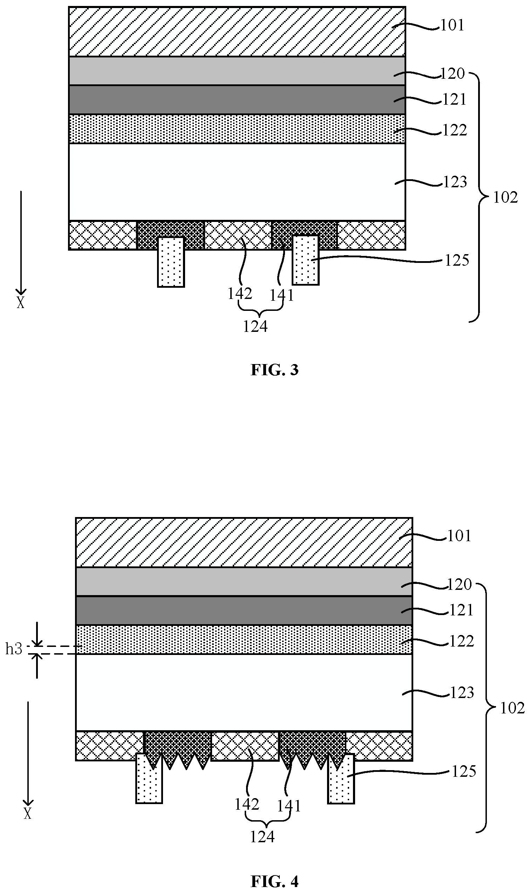

Referring to FIGS. 1 and 3 in combination, FIG. 3 is a schematic diagram of a sectional structure of yet another solar cell. In FIG. 3, the second doped conductive layer 124 has doped regions of different doping concentrations. In some embodiments, the second doped conductive layer 124 has first doped regions 141 and second doped regions 142, and the first doped regions interleave with the second doped regions in a second direction. The doping concentration of the doped ions in the first doped regions 141 is greater than the doping concentration of the doped ions in the second doped regions 142. The one or more electrodes 125 are in ohmic contact with the first doped regions 141.

During forming the second doped conductive layer 124, according to the plan of the one or more electrodes 125 that form ohmic contact with the second doped conductive layer 124, the second doped conductive layer 124 may be formed in such a way that the portions being in contact with the one or more electrodes 125 have higher doping concentration, and other portions have lower doping concentration. That is, after the formation of an undoped semiconductor layer, a large amount of second doped ions are doped into the portions of the semiconductor layer that will come into contact with the one or more electrodes 125 using ion implantation, diffusion doping, or the like, to form initial first doped regions of higher doping concentration. Then, the second doped ions are doped again on a front surface of the semiconductor layer, to passivate the initial first doped regions and restore interface state defects using the second doping. Then light doping of the second doped ions is carried out on the regions other than the initial first doped regions, to form the second doped conductive layer 124 having the first doped regions 141 and the second doped regions 142, where the first doped regions interleave with the second doped regions in the second direction.

The second doped conductive layer 124 has the first doped regions 141 and the second doped regions 142, the first doped regions interleave with the second doped regions, and the one or more electrodes 125 are in ohmic contact with the first doped regions 141 of higher doping concentration. Due to the higher doping concentration of the first doped regions 141, the contact resistance between the one or more electrodes 125 and the second doped conductive layer 124 can be greatly reduced, thereby reducing the collection loss of carriers of the one or more electrodes 125. Moreover, due to the high doping concentration of the first doped regions 141, which are in ohmic contact with the one or more electrodes 125, and the low doping concentration of other regions of the second doped regions 142, the carrier recombination in the second doped conductive layer 124 is relatively low, thereby reducing the impact of carrier recombination on the photoelectric conversion efficiency of the bottom cell 102.

Referring to FIG. 4, FIG. 4 is a schematic diagram of a sectional structure of still another solar cell. In FIG. 4, a surface of the second doped conductive layer 124 has a plurality of textured structures. In some embodiments, surfaces of the first doped regions 141 facing towards the one or more electrodes 125 are textured surfaces. During forming the second doped conductive layer 124, the surface of the second doped conductive layer 124 facing towards the one or more electrodes 125 may be formed as a polished surface first. Then, selective etching is performed on the surface of the second doped conductive layer 124 facing towards the one or more electrodes 125 to transform the surfaces of the first doped regions 141 facing towards the one or more electrodes 125 into textured surfaces.

After forming the one or more electrodes 125, the one or more electrodes 125 contact with the textured surfaces of the first doped regions 141 of the second doped conductive layer 124. Compared with smooth surfaces, the contact area between the one or more electrodes 125 and the second doped conductive layer 124 is significantly increased, thereby reducing the contact resistance between the one or more electrodes 125 and the second doped conductive layer 124, as well as the loss in the one or more electrodes 125 during collection of carriers, which is conducive to improving the photovoltaic conversion efficiency of the solar cell.

Moreover, during forming the second doped conductive layer 124, an initial second doping layer having a smooth surface facing towards the one or more electrodes 125 may be directly formed on the substrate 123 having a smooth surface. Then, selective etching is performed on the surfaces of the first doped regions 141 facing towards the one or more electrodes 125, such that the surface of the second doped conductive layer 124 facing towards the one or more electrodes 125 is etched into a locally textured surface, and that the one or more electrodes 125 are in contact with the textured portions. Alternatively, a surface of the substrate 123 facing towards the second doped conductive layer 124 may be processed in advance, such that portions of the surface of the substrate 123 facing towards the first doped regions 141 are formed as textured surfaces. Then, the second doped conductive layer 124 may be formed on the surface of the substrate 123 using a deposition process. By utilizing the transfer of morphology of the surface during the deposition process, an initial second doped conductive layer whose surface has textured portions can be directly formed, and the second doped conductive layer 124 is formed by performing doping process on the initial second doped conductive layer.

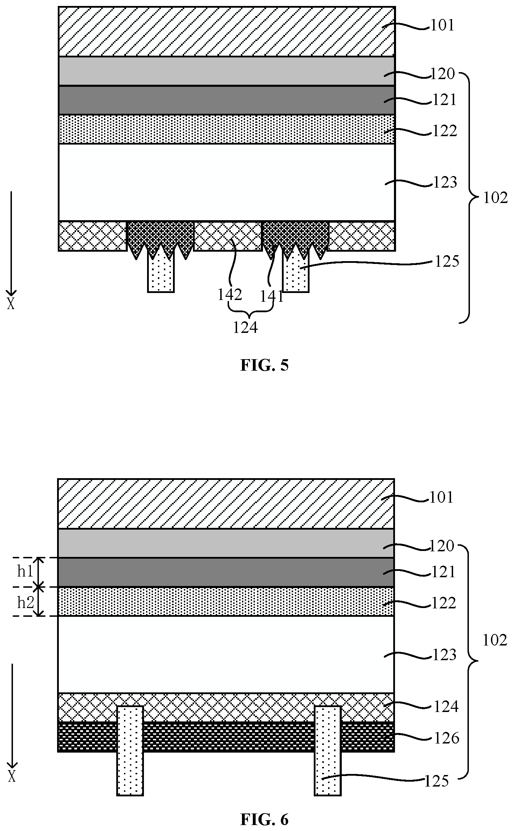

Referring to FIG. 5, FIG. 5 is a schematic diagram of a sectional structure of one more solar cell. In FIG. 5, the one or more electrodes 125 are formed to align with the first doped regions 141. In some embodiments, one or more orthographic projections of the one or more electrodes 125 on a surface of the second doped conductive layer 124 facing towards the one or more electrodes 125 are located within one or more respective first doped regions of the first doped regions 141.

When each electrode of the one or more electrodes 125 is in contact with at least a part of a respective textured portion of the surface of the second doped conductive layer 124, the contact area between the second doped conductive layer 124 and the one or more electrodes 125 can be increased. Based on this, during arranging the one or more electrodes 125 and the second doped conductive layer 124, each electrode of the one or more electrodes 125 may align with a respective first doped region 141 of the second doped conductive layer 124, so that each electrode 125 is totally in contact with a respective portion of the second doped conductive layer 124. That is, the orthographic projection of each electrode 125 on the surface of the second doped conductive layer 124 facing towards the one or more electrodes 125 is completely located within a respective first doped region 141.

By arranging each electrode 125 to align with a respective first doped region 141 and to totally contact with a respective textured portion of the surface of the second doped conductive layer 124, when the textured portions of the surface have a same textured degree, the contact area between the one or more electrodes 125 and the second doped conductive layer 124 can be maximized, and the contact resistance between the one or more electrodes 125 and the second doped conductive layer 124, as well as the collection loss of carriers of the one or more electrodes 125 can be reduced, thereby improving the photoelectric conversion efficiency of the bottom cell 102.

In the bottom cell 102, an orthographic projection of each electrode of at least a portion of the one or more electrodes 125 on the surface of the second doped conductive layer 124 facing towards the one or more electrodes 125 is located within a respective first doped region of the first doped regions 141. Alternatively, an orthographic projection of each electrode of the one or more electrodes 125 on the surface of the second doped conductive layer 124 facing towards the one or more electrodes 125 is located within a respective first doped region of the first doped regions 141.

Referring to FIG. 6, FIG. 6 is a schematic diagram of a sectional structure of one more solar cell. In FIG. 6, the bottom cell 102 further includes a passivation film 126. In some embodiments, the bottom cell 102 further includes a passivation film 126. The passivation film 126 is formed on the surface of the second doped conductive layer 124 of the bottom cell 102 away from the substrate 123 in the first direction. The one or more electrodes 125 are formed on a surface of the passivation film 126 away from the substrate 123 in the first direction, and are in ohmic contact with the second doped conductive layer 124 by penetrating through the passivation film 126.

A material of the passivation film 126 may be at least one of silicon oxide, aluminium oxide, silicon nitride, or silicon oxynitride. The passivation film 126 can reduce the density of defect states on the surface of the substrate 123, suppress carrier recombination in the substrate 123, and reduce the reflection of incident light by the substrate 123, thereby improving the utilization rate of incident light by the substrate 123.

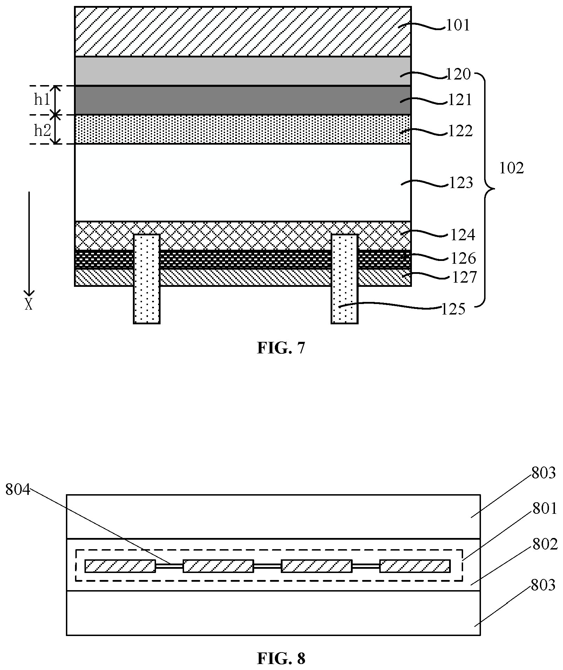

Referring to FIG. 7, FIG. 7 is a schematic diagram of a sectional structure of one more solar cell. In FIG. 7, the bottom cell 102 further includes an anti-reflection layer 127. In some embodiments, the bottom cell 102 further includes an anti-reflection layer 127 formed on the surface of the passivation film 126 away from the substrate 123. The one or more electrodes 125 are formed on a surface of the anti-reflection layer 127 away from the substrate 123 in the first direction, and penetrate through the anti-reflection layer 127 and the passivation film 126, to come into ohmic contact with the second doped conductive layer 124 at the first doped regions 141.

During production of the bottom cell 102, the anti-reflection layer 127 may also be formed on a side of the bottom cell 102 away from the thin-film solar cell 101, and the anti-reflection layer 127 may be used to cover the surface of the passivation film 126 away from the substrate 123 in the first direction. By forming the anti-reflection layer 127 on the side of the bottom cell 102 away from the thin-film solar cell 101, the anti-reflection layer 127 can reduce the reflection of incident light by the bottom cell 102 and improve the light-absorption amount of the bottom cell 102. Moreover, the anti-reflection layer 127 can cooperate with the passivation film 126 to further improve the passivation effect of the bottom cell 102, thereby reducing the carrier recombination in the bottom cell 102 and improving the photoelectric conversion efficiency of the bottom cell.

In some embodiments, a surface of the anti-reflection layer 127 away from the substrate 123 is a textured surface.

During forming the anti-reflection layer 127, the surface of the anti-reflection layer 127 away from the substrate 123 may be formed as a textured surface. The textured structures of the surface of the anti-reflection layer 127 away from the substrate 123 can increase the optical paths of incident light in the bottom cell 102, thereby further improving the light-absorption efficiency of the bottom cell 102.

The surface of the anti-reflection layer 127 away from the substrate 123 may be either a fully textured surface or a partially textured surface. For example, portions of the surface of the anti-reflection layer 127 away from the substrate 123 that align with the second doped regions 142 of the second doped conductive layer 124 are textured, and the remaining portions are smooth. Alternatively, the portions of the surface of the anti-reflection layer 127 away from the substrate 123 that align with the second doped regions 142 of the second doped conductive layer 124 are smooth, and the remaining portions are textured.

In some embodiments, the thin-film solar cell 101 includes a perovskite thin-film solar cell, a CIGS thin-film solar cell, a cadmium telluride thin-film solar cell, or a III to V-group thin-film solar cell.

Because the bottom cell 102 is based on the structure of a TOPCon solar cell, the wavelengths of light that can be absorbed by the bottom cell 102 are usually relatively large. Therefore, as a top cell, the thin-film solar cell 101 may be any one of a perovskite thin-film solar cell, a CIGS thin-film solar cell, a cadmium telluride thin-film solar cell, or a III to V-group thin-film solar cell that can absorb light of relatively small wavelengths.

Some embodiments of the present disclosure provide a tandem solar cell, in the tandem solar cell, the bottom cell 102 is mainly based on a tunnel oxide passivated contact solar cell, with a back structure of the tunnel oxide passivated contact solar cell being replaced with a back structure of a heterojunction solar cell, and the thin-film solar cell 101 and the bottom cell 102 are connected using the transparent conductive layer 120 in the back structure of the heterojunction solar cell. With the replacement of the back structure of the bottom cell 102, the bottom cell 102 can have a complete back structure, which can improve the open-circuit voltage of the bottom cell 102, and can prevent the formation of metal-semiconductor contact between the back electrodes of the bottom cell 102 and an intermediate layer when the bottom cell 102 having the complete back structure is connected with the thin-film solar cell 101 through the intermediate layer. In this way, the contact recombination between the thin-film solar cell 101 and the bottom cell 102 can be reduced, and the photoelectric conversion efficiency of the solar cell can be improved. Moreover, due to the transparent conductive layer 120 in the structure of the bottom cell 102 on a side facing to the thin-film solar cell 101, there is no need to form an additional intermediate layer to connect the bottom cell 102 and the thin-film solar cell 101, thereby reducing the overall thickness and cost of the tandem solar cell.

Some embodiments of the present disclosure provide a photovoltaic module. Referring to FIG. 8, the photovoltaic module includes one or more cell strings 801 formed by connecting a plurality of the solar cells as described above; one or more encapsulation layers 802 configured to cover at least one surface of the one or more cell strings 801; and one or more cover plates 803 configured to cover at least one surface of the one or more encapsulation layers 802 away from the one or more cell strings 801. Solar cells are electrically connected in whole or electrically connected in a form of multiple pieces to form a plurality of cell strings 801, and the plurality of cell strings 801 are electrically connected in series and/or in parallel.

In some embodiments, the plurality of cell strings 801 may be electrically connected using conductive strips 804. The one or more encapsulation layers 802 cover the front and back surfaces of the solar cells. In some embodiments, the encapsulation layer 802 may be an organic encapsulation adhesive film such as an ethylene vinyl acetate copolymer (EVA) adhesive film, a polyethylene octene co-elastomer (POE) adhesive film, or a polyethylene glycol terephthalate (PET) adhesive film. In some embodiments, the cover plate 803 may be a glass cover plate, a plastic cover plate, or other cover plates having light transmission function. The surface of the cover plate 803 facing towards the encapsulation layer 802 may be a textured surface, thereby increasing the utilization rate of incident light.

Although the present disclosure is described with reference to above preferred embodiments, the claims are not limited to these embodiments. Various possible changes and modifications may be made by those skilled in the art on the basis of the concepts of the present disclosure, without departing from the spirit and scope of the present disclosure. Therefore, the scope of protection of the present disclosure shall be subject to the scope defined by the claims.

## Claims

1. A solar cell, comprising a thin-film solar cell (101) and a bottom cell (102) stacked in a first direction (X), wherein the bottom cell (102) includes:
a transparent conductive layer (120), a first doped conductive layer (121), an amorphous silicon layer (122), a substrate (123), and a second doped conductive layer (124) that are stacked in the first direction (X), wherein the transparent conductive layer (120) is between the thin-film solar cell (101) and the first doped conductive layer (121), and the first doped conductive layer (121) includes amorphous silicon or microcrystalline silicon; and
one or more electrodes (125) formed on a side of the second doped conductive layer (124) away from the substrate (123) and are in ohmic contact with the second doped conductive layer (124);
wherein a type of a doping element in the second doped conductive layer 124 is different from a type of a doping element in the substrate (123), and a type of a doping element in the first doped conductive layer (121) is same as the type of the doping element in the substrate (123).

2. The solar cell according to claim 1, wherein a surface of the substrate (123) facing towards the amorphous silicon layer (122) has a plurality of textured structures.

3. The solar cell according to claim 2, wherein heights of the plurality of textured structures of the surface of the substrate (123) facing towards the amorphous silicon layer (122) in the first direction (X) range from 50nm to 1µm.

4. The solar cell according to claim 1, wherein the first doped conductive layer (121) has a first doped element, and doping concentration of the first doped element ranges from 10¹⁷/cm³ to 10¹⁹/cm³.

5. The solar cell according to any one of claims 1 to 3, wherein the second doped conductive layer (124) has first doped regions (141) and second doped regions (142), and the first doped regions (141) interleave with the second doped regions (142) in a second direction;
wherein doping concentration of a doped element in the first doped regions (141) is greater than doping concentration of a doped element in the second doped regions (142); and
the one or more electrodes (125) are in ohmic contact with the first doped regions (141).

6. The solar cell according to claim 5, wherein surfaces of the first doped regions (141) facing towards the one or more electrodes (125) are textured surfaces.

7. The solar cell according to claim 5, wherein one or more orthographic projections of the one or more electrodes (125) on a surface of the second doped conductive layer (124) facing towards the one or more electrodes (125) are located within one or more respective first doped regions of the first doped regions (141).

8. The solar cell according to claim 5, wherein the bottom cell (102) further includes a passivation film (126) formed on the surface of the second doped conductive layer (124) away from the substrate (123), and the one or more electrodes (125) are formed on a side of the passivation film (126) away from the substrate (123) and are in ohmic contact with the second doped conductive layer (124) by penetrating through the passivation film (126).

9. The solar cell according to claim 8, wherein a material of the passivation film (126) includes at least one of silicon oxide, aluminium oxide, silicon nitride, or silicon oxynitride.

10. The solar cell according to claim 8 or claim 9, wherein the bottom cell (102) further includes an anti-reflection layer (127) formed on the surface of the passivation film (126) away from the substrate (123), the one or more electrodes (125) are formed on a surface of the anti-reflection layer (127) away from the substrate (123) and penetrate through the anti-reflection layer (127) and the passivation film (126), and the one or more electrodes (125) are in ohmic contact with the second doped conductive layer (124) at the first doped regions (141).

11. The solar cell according to claim 10, wherein a surface of the anti-reflection layer (127) away from the substrate (123) has portions that are formed over the second doped regions (142) of the second doped conductive layer (124) and are textured, and remaining portions of the surface of the anti-reflection layer (127) away from the substrate (123) are smooth.

12. The solar cell according to any one of claims 1 to 11, wherein a thickness of the first doped conductive layer (121) in the first direction (X) ranges from 5nm to 30nm.

13. The solar cell according to any one of claims 1 to 12, wherein a thickness of the amorphous silicon layer (122) in the first direction (X) ranges from 1nm to 10nm.

14. The solar cell according to any one of claims 1 to 13, wherein the thin-film solar cell (101) includes a perovskite thin-film solar cell, a copper indium gallium diselenide, CIGS, thin-film solar cell, a cadmium telluride thin-film solar cell, or a III to V-group thin-film solar cell.

15. A photovoltaic module, comprising:
one or more cell strings (801) formed by connecting a plurality of the solar cells according to any one of claims 1 to 14;
one or more encapsulation layers (802) configured to cover at least one surface of the one or more cell strings (801); and
one or more cover plates (803) configured to cover at least one surface of the one or more encapsulation layers (802) away from the one or more cell strings (801).
